# DEMANDE DE BREVET EUROPEEN

(11) **EP 3 503 175 A1**
(43) Date de publication de la demande: **26.06.2019**
(21) Numéro de dépôt: 18214900.5
(22) Date de dépôt: 20.12.2018
(51) Int. Cl.: H01L 21/84, H01L 21/762, H01L 29/78, H01L 29/06, H01L 29/786, H01L 21/8238, H01L 21/225

(54) **PROCEDE DE REALISATION D'UN SUBSTRAT SEMI-CONDUCTEUR COMPRENANT AU MOINS UNE PORTION DE SEMI-CONDUCTEUR CONTRAINT EN COMPRESSION**

(30) Priorité: 22.12.2017 US 201715852671
(71) Demandeur: Commissariat à l'énergie atomique et aux énergies alternatives, 75015 Paris (FR)
(72) Inventeur: REBOH, Shay, 38054 GRENOBLE Cedex 09 (FR)
(74) Mandataire: Brevalex

(57) **Abrégé**

Procédé de réalisation d'un substrat semi-conducteur (100), comprenant :
- réalisation d'une couche semi-conductrice (16) telle qu'une première partie (24) de la couche semi-conductrice comporte un semi-conducteur contraint en compression et qu'une deuxième partie (26) de la couche semi-conductrice comporte un matériau différent du semi-conducteur contraint en compression, la deuxième partie de la couche semi-conductrice étant disposée, dans un plan principal de la couche semi-conductrice, contre au moins deux bords (25) opposés de la première partie de la couche semi-conductrice ;
- gravure, à travers la couche semi-conductrice, d'une tranchée délimitant, vis-à-vis du reste de la couche semi-conductrice, la première partie de la couche semi-conductrice et des portions (32) de la deuxième partie de la couche semi-conductrice disposées contre les bords opposés de la première partie de la couche semi-conductrice.

## Description

### DOMAINE TECHNIQUE ET ART ANTÉRIEUR

L'invention concerne le domaine de la réalisation de substrats adaptés à la réalisation d'un ou plusieurs dispositifs semi-conducteurs et comprenant une portion de semi-conducteur contraint en compression pour la réalisation de ce ou des dispositifs semi-conducteurs. L'invention s'applique avantageusement à la réalisation, dans la portion de semi-conducteur contraint en compression, de transistors FET (« Field Effect Transistor », ou transistor à effet de champ) de type P comprenant une zone active de SiGe contraint en compression. L'invention permet en outre l'intégration, sur une même couche semi-conductrice, de transistors FET de type P ayant des canaux contraints en compression et d'éventuels autres transistors FET, par exemple de type N et ayant des canaux non contraints en compression ou bien d'autres transistors de type P ayant des canaux contraints en compression ou non contraints en compression.

Un matériau cristallin déformé mécaniquement correspond à un matériau qui a son ou ses paramètre(s) de maille cristalline allongé(s) ou écourté(s). Dans le cas où le paramètre de maille déformé est plus important que le paramètre dit « naturel » du matériau cristallin, celui-ci est dit en déformation en tension. Lorsque le paramètre de maille déformé est plus petit que le paramètre de maille naturel, le matériau est dit en déformation compressive ou en compression.

A ces états de déformation mécanique d'un matériau cristallin, on associe des états de contraintes mécaniques. Pour autant, il est également commun de se référer à ces états de déformation comme des états de contraintes mécaniques. Dans la présente demande, cette notion de déformation (« strain » selon la terminologie anglo-saxonne) est désignée de façon générique par le terme « contrainte ».

Afin d'améliorer les performances d'un transistor, celui-ci peut être réalisé avec un canal contraint, c'est-à-dire dont le semi-conducteur formant le canal comporte une contrainte. Cette contrainte peut avoir un caractère uni-axial et être orientée parallèlement à la longueur du canal (c'est-à-dire la dimension du canal qui est sensiblement parallèle à la direction de circulation du courant dans le canal), ou un caractère bi-axial, c'est-à-dire être orientée selon deux droites sensiblement perpendiculaires l'une par rapport à l'autre et dont l'une est parallèle à la longueur du canal et l'autre est parallèle à la largeur du canal (c'est-à-dire la dimension du canal qui est, dans le plan principal de la couche dans laquelle est formé le canal, sensiblement perpendiculaire à la direction de circulation du courant dans le canal).

Dans un transistor MOSFET de type P, une contrainte compressive, ou contrainte en compression, du canal permet d'améliorer la mobilité des porteurs de charges dans le canal. Dans un transistor MOSFET de type N, c'est une contrainte en tension du canal qui permet d'améliorer la mobilité des porteurs de charges dans le canal.

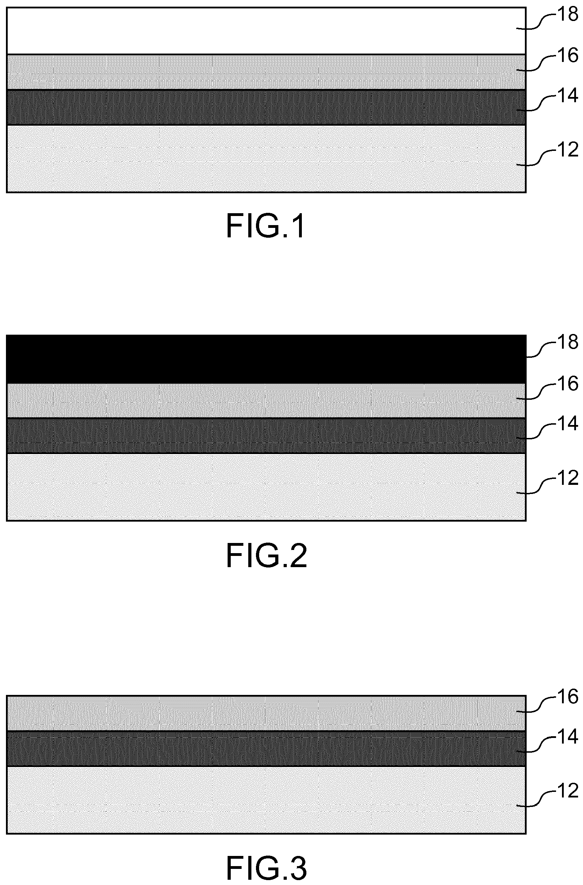

Pour la réalisation d'un tel transistor FET de type P avec un canal contraint en compression, un substrat comprenant une couche active (couche dans laquelle la zone active du transistor est réalisée) dont au moins une région comporte du semi-conducteur contraint en compression est utilisé. Un exemple de réalisation d'un tel substrat 10 est décrit en lien avec les figures 1 à 3.

Le substrat 10 est réalisé à partir d'un substrat de type semi-conducteur sur isolant, ici SOI (« Silicon On Insulator », ou silicium sur isolant). Le substrat SOI comporte une couche support 12, ou couche épaisse, sur laquelle se trouve une couche diélectrique enterrée 14, ou BOX (« Buried Oxide »), comprenant par exemple du SiO₂ et dont l'épaisseur est par exemple comprise entre environ 25 nm et 200 nm, et une couche superficielle 16, ou couche mince, dont l'épaisseur est par exemple comprise entre environ 5 nm et 30 nm, comprenant ici du silicium et dans laquelle les zones actives des transistors FET sont destinées à être réalisées.

Une couche 18 de SiGe est tout d'abord formée par épitaxie sur la ou les parties de la couche superficielle 16 dans lesquelles du SiGe contraint en compression est destiné à être réalisé, par exemple dans la ou les régions de la couche superficielle 16 dans lesquelles des transistors FET de type P sont destinés à être réalisés (figure 1). Cette localisation de la couche 18 sur la ou les parties de la couche superficielle 16 souhaitées peut être obtenue en utilisant un masque dont la ou les ouvertures sont localisées au-dessus de cette ou ces parties de la couche superficielle 16. Sur les figures 1 à 5, la couche de SiGe 18 recouvre toute la couche superficielle 16.

Une étape d'oxydation de la couche 18 de SiGe est ensuite mise en oeuvre. Cette oxydation entraîne une migration d'atomes de germanium issus de la couche 18 dans le silicium de la couche superficielle 16. Cet enrichissement en germanium du silicium de la couche 16 modifie la nature du silicium de la couche 16 qui devient du SiGe contraint en compression. Sur la figure 2 qui correspond à la structure obtenue à l'issue de cette étape d'oxydation, la couche 18 comporte majoritairement du SiO₂ et la couche 16 comporte du SiGe contraint en compression.

La couche d'oxyde 18 formée par l'oxydation du SiGe est ensuite retirée (figure 3). L'empilement des couches restantes 12, 14 et 16 forment ensemble un substrat de type SiGeOI avec du SiGe contraint en compression formant la couche superficielle de ce substrat.

Cette technique de réalisation du SiGe, appelée condensation de Ge ou enrichissement de Ge, est par exemple décrite dans le document « The Ge condensation technique: A solution for planar SOI/GeOI co-integration for advanced CMOS technologies? » de B. Vincent et al., Material Science in Semiconductor Processing 11 (2008) pages 205-213.

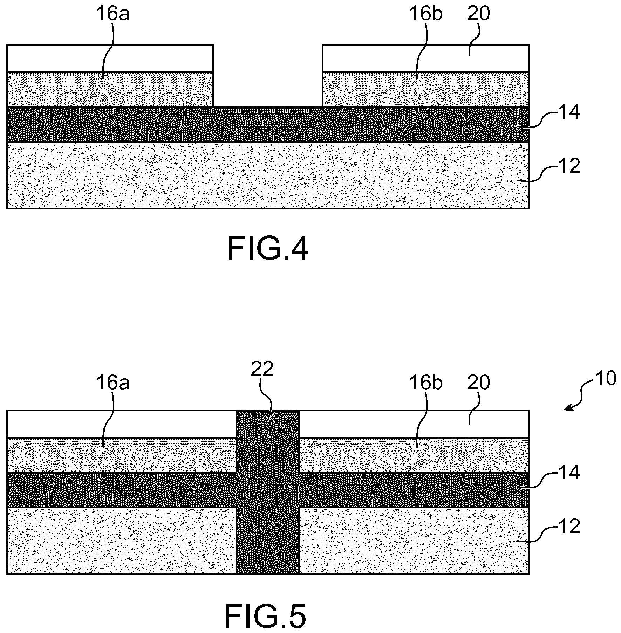

A partir d'un tel substrat, différentes étapes technologiques sont ensuite mises en oeuvre. La réalisation de tranchées d'isolation STI (« Shallow Trench Isolation », ou tranchée d'isolation peu profonde) au sein du substrat, impliquent de graver la couche 16 pour former des portions distinctes, ou isolées, de SiGe. Ainsi, sur la figure 4, un masque de gravure 20 est déposé sur la couche 16, puis cette couche 16 est gravée conformément aux ouvertures du masque 20. Cette gravure peut être prolongée à travers la couche diélectrique enterrée 14 et dans la couche support 12 (comme c'est le cas dans le procédé décrit ici), puis une tranchée d'isolation 22 est formée en déposant un matériau diélectrique dans la tranchée gravée (figure 5). Le substrat 10 comprenant différentes parties isolées par des tranchées d'isolation 22 est ainsi obtenu. Lorsque du SiGe contraint en compression est formé dans une ou plusieurs parties de la couche superficielle 16, une ou plusieurs autres parties de la couche superficielle 16 étant conservées en silicium, les tranchées d'isolation 22 peuvent être réalisées aux interfaces SiGe/Si présentes dans la couche superficielle 16.

Un problème rencontré avec le procédé décrit ci-dessus est qu'après avoir gravé la ou les tranchées à travers la couche 16, une réduction de la contrainte en compression plus importante que celle due à la seule relaxation élastique du semi-conducteur, est obtenue dans le semi-conducteur contraint en compression. Les effets bénéfiques liés à cette contrainte et obtenus dans des transistors réalisés dans un tel substrat sont donc fortement réduits.

Le document FR 3 046 492 propose un procédé dans lequel les tranchées d'isolation sont remplacées par des barres d'oxyde formées par oxydation de portions du semi-conducteur de la couche active. En évitant de graver la couche superficielle, on évite la réduction importante de la contrainte décrite précédemment. Toutefois, un tel procédé n'est pas adapté aux régions où la présence de tranchées d'isolation est nécessaire.

### EXPOSÉ DE L'INVENTION

Un but de la présente invention est de proposer un procédé de réalisation d'un substrat semi-conducteur adapté à la réalisation d'au moins un dispositif semi-conducteur, notamment au moins un transistor FET de type P, dans au moins une portion de semi-conducteur contraint en compression du substrat semi-conducteur, dans lequel une relaxation excessive du semi-conducteur contraint est évitée au cours de la réalisation du substrat, et qui soit compatible avec la réalisation de tranchées d'isolation traversant la couche active et au moins une partie d'une ou plusieurs couches présentes sous la couche active.

Pour cela, l'invention propose un procédé de réalisation d'un substrat semi-conducteur, comprenant au moins la mise en oeuvre des étapes suivantes :
- réalisation d'une couche semi-conductrice telle qu'au moins une première partie de la couche semi-conductrice comporte un semi-conducteur contraint en compression et qu'au moins une deuxième partie de la couche semi-conductrice comporte au moins un matériau différent du semi-conducteur contraint en compression, la deuxième partie de la couche semi-conductrice étant disposée, dans un plan principal de la couche semi-conductrice, contre au moins deux premiers bords opposés de la première partie de la couche semi-conductrice ;
- gravure, au moins à travers la couche semi-conductrice, d'au moins une tranchée délimitant, vis-à-vis du reste de la couche semi-conductrice, la première partie de la couche semi-conductrice et des portions de la deuxième partie de la couche semi-conductrice disposées contre lesdits au moins deux premiers bords opposés de la première partie de la couche semi-conductrice.

Dans ce procédé, la couche semi-conductrice est conçue telle qu'un matériau différent du semi-conducteur contraint en compression soit présent contre au moins deux bords opposés de la première partie de la couche semi-conductrice qui comporte le semi-conducteur contraint en compression. Cet autre matériau est utilisé judicieusement pour qu'il forme, au moins au niveau des deux bords opposés de la portion de semi-conducteur contraint en compression, des portions de matériau permettant de d'éviter la relaxation excessive du semi-conducteur contraint lors de la gravure de la ou des tranchées qui délimitent la partie de semi-conducteur contraint en compression et ces portions de matériau vis-à-vis du reste de la couche semi-conductrice. Contrairement aux procédés de l'art antérieur dans lesquels les différentes parties de la couche semi-conducteur sont séparées les unes des autres par une ou plusieurs tranchées d'isolation, des portions de la deuxième partie de la couche semi-conductrice sont incluses, avec la première partie de la couche semi-conductrice comprenant le semi-conducteur contraint en compression, dans la région délimitée par la ou les tranchées. Ainsi, le semi-conducteur contraint en compression ne se relaxe pas excessivement (au moins selon la direction sensiblement perpendiculaire aux deux premiers bords opposés de la première partie de la couche semi-conductrice) suite à la gravure de la ou des tranchées à travers la couche semi-conductrice, ce qui permet de maintenir un bon niveau de contrainte en compression dans la première partie de la couche semi-conductrice, nonobstant la gravure de la tranchée.

En outre, grâce à la présence des portions de la deuxième partie de la couche semi-conductrice interposées entre la première partie de la couche semi-conductrice et la ou les tranchées, cette ou ces tranchées peuvent être réalisées avec n'importe quelle profondeur tout en évitant une relaxation excessive de la contrainte, et peuvent notamment traverser au moins une partie de l'épaisseur d'une ou plusieurs autres couches disposées sous la couche semi-conductrice.

Un tel substrat est bien adapté pour réaliser en technologie CMOS un ou plusieurs transistors FET de type P ayant un canal contraint en compression dans la première partie de la couche semi-conductrice, et un ou plusieurs autres transistors FET, par exemple de type P ou N et ayant un canal contraint ou non en compression, dans une autre partie du substrat.

Un tel substrat est bien adapté à la réalisation de transistors FET de type FDSOI, et/ou de transistors FET de type P comprenant un canal de SiGe contraint en compression.

Le plan principal de la couche semi-conductrice correspond à un plan parallèle au substrat, c'est-à-dire parallèle aux faces principales de la couche semi-conductrice qui correspondent aux deux faces de plus grandes dimensions de la couche semi-conductrice.

Le matériau différent du semi-conducteur contraint en compression peut ne pas comporter une contrainte en compression ou comporter une contrainte en compression de niveau, ou d'intensité, inférieur à celui de la contrainte en compression dans le semi-conducteur de la première partie de la couche semi-conductrice. Ce matériau correspond par exemple à un semi-conducteur non contraint ou un semi-conducteur contraint en tension.

La première partie de la couche semi-conductrice peut avoir, dans le plan principal de la couche semi-conductrice, une section de forme sensiblement rectangulaire ou combinant plusieurs rectangles.

Les portions de la deuxième partie de la couche semi-conductrice peuvent entourer entièrement la première partie de la couche semi-conductrice dans le plan principal de la couche semi-conductrice. Dans ce cas, une relaxation excessive de la contrainte dans le semi-conducteur de la première partie de la couche semi-conductrice est évitée au niveau de tous les bords de la première partie de la couche semi-conductrice. Dans cette configuration et lorsque la première partie de la couche semi-conductrice a, dans le plan principal de la couche semi-conductrice, une section délimitée par des bords orientés selon deux directions sensiblement perpendiculaires l'une par rapport à l'autre, la relaxation excessive de la contrainte est évitée selon ces deux directions.

En variante, au moins deux deuxièmes bords opposés de la première partie de la couche semi-conductrice, sensiblement perpendiculaires aux deux premiers bords, peuvent être en contact avec la tranchée, c'est-à-dire sans présence de portions de la deuxième partie de la couche semi-conductrice entre ces deuxièmes bords de la première partie de la couche semi-conductrice et la tranchée. Dans ce cas, une relaxation partielle de la contrainte selon une direction sensiblement perpendiculaire aux deux deuxièmes bords est permise, tout en évitant cette relaxation excessive de cette contrainte selon la direction sensiblement perpendiculaire aux deux premiers bords.

Le semi-conducteur contraint en compression peut comporter du SiGe et/ou le matériau différent du semi-conducteur contraint en compression peut comporter du silicium. Selon une configuration particulière, ce silicium peut être contraint en tension.

Dans ce cas, lorsque le semi-conducteur contraint en compression comporte du SiGe et que le matériau différent du semi-conducteur contraint en compression comporte du silicium, la couche semi-conductrice peut être réalisée par enrichissement en germanium, ou condensation de germanium, dans une couche de silicium.

Par exemple, la couche semi-conductrice peut être réalisée par la mise en oeuvre des étapes suivantes :
- épitaxie d'une couche de SiGe sur au moins une première partie d'une couche de silicium destinée à former ladite première partie de la couche semi-conductrice, au moins une deuxième partie de la couche de silicium non recouverte par la couche de SiGe étant destinée à former ladite deuxième partie de la couche semi-conductrice ;
- oxydation de la couche de SiGe, provoquant un enrichissement en germanium de la première partie de la couche de silicium et formant la première partie de la couche semi-conductrice qui comporte du SiGe contraint en compression ;
- retrait d'une couche d'oxyde formée par l'oxydation de la couche de SiGe.

Avant la mise en oeuvre de l'enrichissement en germanium, la couche de silicium peut comporter du silicium contraint en tension. Par exemple, la couche de silicium peut correspondre à la couche superficielle d'un substrat sSOI (« strained Silicon On Insulator », ou silicium contraint sur isolant). Une partie des atomes de germanium introduits dans la couche de silicium lors de l'enrichissement en germanium servent à annuler la contrainte en tension dans la première partie de la couche de silicium, et les autres atomes de germanium introduits dans la couche de silicium servent à apporter la contrainte en compression dans la première partie de la couche de silicium.

En outre, le semi-conducteur contraint en compression, correspondant à du SiGe, peut comporter une concentration en germanium comprise entre environ 20 % et 50 %. Il est toutefois possible que cette concentration en germanium soit comprise entre environ 20 % et 100 % (avec, dans le cas d'une concentration en germanium égale à 100 %, un semi-conducteur contraint en compression correspondant à du germanium). La concentration en germanium dans le semi-conducteur correspond ici au pourcentage atomique de germanium au sein de ce semi-conducteur.

Le procédé peut comporter en outre, après la gravure de la tranchée, la mise en oeuvre d'une étape de formation d'au moins un matériau diélectrique dans la tranchée, formant une tranchée d'isolation électrique de la première partie de la couche semi-conductrice et des portions de la deuxième partie de la couche semi-conductrice.

Lors de la réalisation de la couche semi-conductrice, une couche diélectrique enterrée peut être disposée entre la couche semi-conductrice et une couche support.

Dans ce cas, la tranchée peut traverser la couche diélectrique enterrée et une partie de l'épaisseur de la couche support. Une telle tranchée est notamment réalisée lorsqu'une réalisation de tranchées de type STI est nécessaire.

Le procédé peut être tel que :
- la couche semi-conductrice est réalisée telle qu'elle comporte plusieurs premières parties comprenant le semi-conducteur contraint en compression, la deuxième partie de la couche semi-conductrice étant disposée, dans le plan principal de la couche semi-conductrice, contre au moins les deux premiers bords opposés de chacune des premières parties de la couche semi-conductrice, et
- la tranchée est gravée en délimitant les premières parties de la couche semi-conductrice et des portions de la deuxième partie de la couche semi-conductrice disposées contre lesdits au moins deux premiers bords opposés de chacune des premières parties de la couche semi-conductrice.

L'invention concerne également un procédé de réalisation d'au moins un transistor FET, dans lequel ledit au moins un transistor FET est de type P et est réalisé dans la première partie de la couche semi-conductrice d'un substrat semi-conducteur obtenu par la mise en oeuvre du procédé de réalisation décrit précédemment.

De manière avantageuse, un ou plusieurs transistors FET de type P peuvent être réalisés dans la portion de semi-conducteur contraint en compression, et une dimension d'au moins une des portions de la deuxième partie de la couche semi-conductrice, dans le plan principal de la couche semi-conductrice et sensiblement perpendiculaire à un bords latéral de la tranchée, peut être telle que ladite au moins une des portions de la deuxième partie de la couche semi-conductrice ne soit pas disposée dans le canal du ou de chacun des transistors FET de type P, ou ne soit pas disposée dans une zone active du ou de chacun des transistors FET de type P.

Ledit au moins un transistor FET peut être réalisé dans la première partie de la couche semi-conductrice tel que les portions de la deuxième partie de la couche semi-conductrice ne soient pas disposées dans le canal dudit au moins un transistor FET.

Ledit au moins un transistor FET peut avoir son canal orienté sensiblement perpendiculairement aux deux premiers bords opposés de la première partie de la couche semi-conductrice.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 5 représentent un procédé de réalisation d'un substrat semi-conducteur comprenant une couche de semi-conducteur contraint en compression ;
- les figures 6 à 13 représentent un procédé de réalisation d'un substrat semi-conducteur et un procédé de réalisation de transistors FET dans au moins une portion de semi-conducteur contraint en compression du substrat, objet de la présente invention, selon un mode de réalisation particulier;
- les figures 14 à 16 représentent des variantes du procédé de réalisation d'un substrat semi-conducteur, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

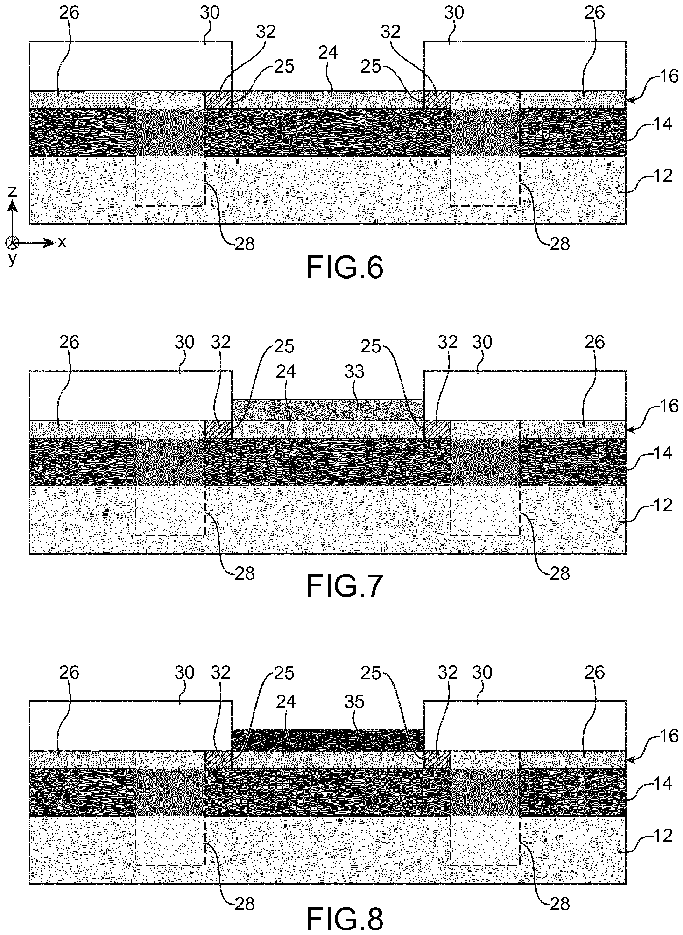

Un mode de réalisation particulier d'un procédé de réalisation d'un substrat semi-conducteur 100 adapté à la réalisation d'au moins un dispositif semi-conducteur, tel qu'un ou plusieurs transistors FET, dans au moins une portion de semi-conducteur contraint en compression du substrat, est représenté sur les figures 6 à 13.

Ce procédé est mis en oeuvre à partir d'un substrat SOI similaire à celui précédemment décrit en lien avec les figures 1 à 5, et comportant la couche support 12, la couche diélectrique enterrée 14 et la couche superficielle 16 de silicium qui a par exemple une épaisseur comprise entre environ 6 nm et 8 nm.

Une première étape est mise en oeuvre pour former différentes parties à base de différents matériaux au sein de la couche superficielle 16. Une ou plusieurs premières parties 24 comprenant du semi-conducteur contraint en compression, ici du SiGe, sont destinées à être réalisées pour la formation de transistors FET de type P, et une ou plusieurs deuxièmes parties 26 comprenant du semi-conducteur non contraint, ici du silicium, par exemple destinées à être réalisées pour la formation de transistors FET de type N. L'isolation des différentes parties de la couche superficielle 16 est destinée à être assurée par des tranchées d'isolation, par exemple de type STI.

Dans l'exemple décrit ici en lien avec les figures 6 à 13, une seule première partie 24 et une seule deuxième partie 26 formée autour de la première partie 24 sont réalisées dans la couche superficielle 16. Les emplacements de la ou des tranchées d'isolation destinées à isoler la zone de réalisation des transistors de type P vis-à-vis du reste de la couche superficielle 16 sont représentés symboliquement en trait pointillé référencé 28. En outre, la première partie 24 est destinée à être formée de SiGe contraint en compression, et la deuxième partie 26 est destinée à être formée du silicium initial de la couche superficielle 16.

Au cours de cette première étape, un premier masque 30 est réalisé sur la couche superficielle 16 pour définir la ou les parties de la couche superficielle 16 dont le semi-conducteur est destiné à être modifié pour devenir du SiGe contraint en compression, et la ou les parties de la couches superficielle 16 dont le semi-conducteur est destiné à être du silicium. Sur la figure 6, ce premier masque 30 ne recouvre pas la première partie 24 de la couche superficielle 16 destinée à être formée de SiGe contraint en compression et recouvre la deuxième partie 26 de la couche superficielle 16 destinée à être formée de silicium.

Le premier masque 30 est par exemple formé d'une première couche de SiO₂ d'épaisseur comprise entre environ 5 nm et 10 nm, et d'une deuxième couche de SiN d'épaisseur comprise entre environ 30 nm et 100 nm.

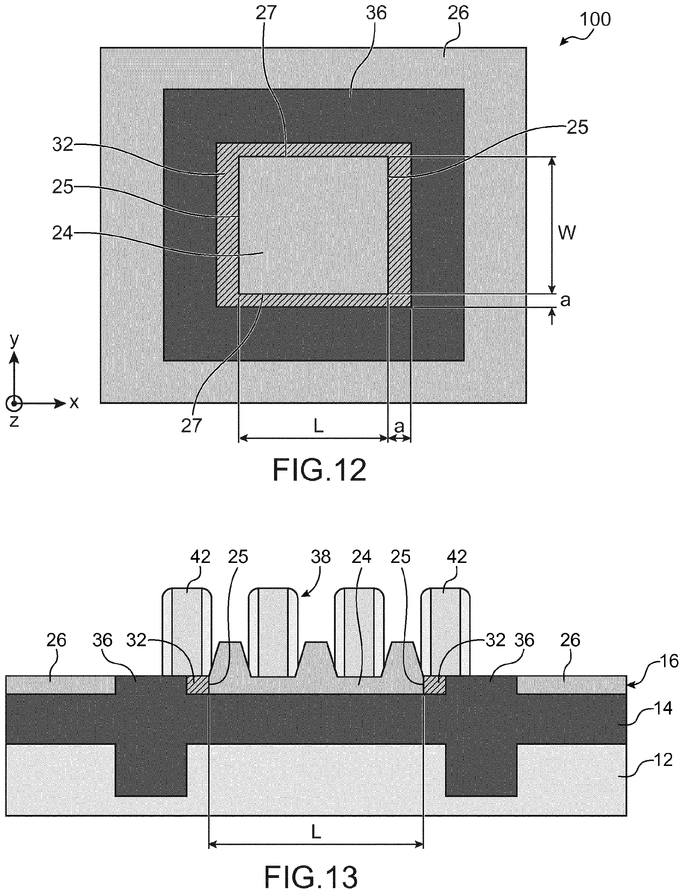

Comme cela est visible sur la figure 6, les bords du premier masque 30 délimitant les première et deuxième parties 24, 26 de la couche superficielle 16 ne sont pas alignés avec les emplacements prévus pour former ultérieurement la ou les tranchées d'isolation 28. En effet, le motif du premier masque 30 définit les première et deuxième parties 24, 26 de la couche superficielle 16 telles que des portions 32 de la deuxième partie 26 de la couche superficielle 16, c'est-à-dire destinée à être formée de silicium, soient incluses dans la zone destinée à la réalisation des transistors de type P, contre au moins deux premiers bords 25 opposés de la première partie 24 de la couche superficielle 16. Dans le mode de réalisation particulier décrit ici, la deuxième partie 26 de la couche superficielle 16 est disposée tout autour de la première partie 24 de la couche superficielle 16 qui est destinée à être formée de SiGe contraint en compression. Ainsi, des portions 32 de la deuxième partie 26 de la couche superficielle 16 sont également disposées contre au moins deux deuxièmes bords 27 (visibles sur la figure 12) opposés de la première partie 24 de la couche superficielle 16 et qui sont sensiblement perpendiculaires aux deux premiers bords 25. Les bords de la zone servant à la réalisation des transistors de type P sont ici destinés à être délimités par les portions 32. Sur la figure 6, ces portions 32 sont représentées de manière hachurée afin de les distinguer vis-à-vis des autres parties de la couche superficielle 16.

Après avoir réalisé le premier masque 30 sur la couche superficielle 16, les étapes permettant de transformer le silicium de la première partie 24 de la couche superficielle 16 en SiGe contraint en compression sont mises en oeuvre. Pour cela, une couche de SiGe 33 est tout d'abord formée par épitaxie sur la première partie 24 de la couche superficielle 16 qui n'est pas recouverte par le premier masque 30 (voir la figure 7). Cette couche de SiGe 33 a par exemple une épaisseur comprise entre environ 5 nm et 30 nm, et le pourcentage de germanium dans le SiGe de cette couche, c'est-à-dire le pourcentage atomique de germanium dans ce SiGe, est par exemple compris entre environ 20 % et 50 %. Cette couche de SiGe 33 peut être recouverte d'une couche d'oxyde de silicium (non visible sur la figure 7) d'épaisseur par exemple comprise entre environ 5 nm et 50 nm.

Une étape d'oxydation thermique de cette couche de SiGe 33 est ensuite mise en oeuvre. Cette oxydation peut comporter par exemple une première étape d'oxydation sèche, par exemple par oxydation thermique rapide (RTO pour « Rapid Thermal Oxidation ») mise en oeuvre à une température comprise entre environ 850°C et 950°C, ou entre 900°C et 1100°C pour diffuser les atomes de germanium. Une deuxième étape de recuit sous une atmosphère neutre, par exemple sous une atmosphère de N₂, peut être mise en oeuvre, par exemple à une température supérieure à la température de mise en oeuvre de la précédente oxydation et comprise entre environ 950°C et 1100°C pour homogénéiser la concentration de Ge dans la couche. Les températures mises en jeu lors de cette oxydation sont telles qu'elles soient inférieures à la température de fusion du semi-conducteur contraint de la première partie 24. Ces deux étapes peuvent être mises en oeuvre une seule fois, avec dans ce cas une première étape d'oxydation mise en oeuvre pendant une durée suffisante pour obtenir, à l'issue de cette première étape, la concentration en germanium souhaitée dans le semi-conducteur de la première partie 24 de la couche superficielle 16. En variante, ces deux étapes peuvent être mises en oeuvre plusieurs fois l'une après l'autre de manière cyclique, avec dans ce cas des durées de mise en oeuvre des premières étapes d'oxydation réduites. L'enrichissement en germanium du semi-conducteur de la première partie 24 obtenu peut être tel que le taux de germanium dans le SiGe contraint obtenu soit compris entre environ 20 % et 50 %.

Cette oxydation provoque une migration d'atomes de germanium issus de la couche de SiGe 33 dans le silicium de la première partie 24 de la couche superficielle 16. Cet enrichissement en germanium du silicium modifie la nature de ce semi-conducteur qui devient du SiGe contraint en compression. A l'issue de cette étape, le semi-conducteur de la première partie 24 de la couche superficielle 16, c'est-à-dire le semi-conducteur de la couche superficielle 16 qui n'est pas recouvert par le premier masque 30, correspond à du SiGe contraint en compression. Grâce à la présence du premier masque 30 recouvrant la deuxième partie 26 de la couche superficielle 16, la nature du silicium de cette deuxième partie 26 n'est pas modifiée par la mise en oeuvre de ces étapes. Une couche d'oxyde 35 formée par l'oxydation de la couche de SiGe 33 (visible sur la figure 8), comprenant par exemple majoritairement du SiO₂, et le premier masque 30 sont ensuite retirés.

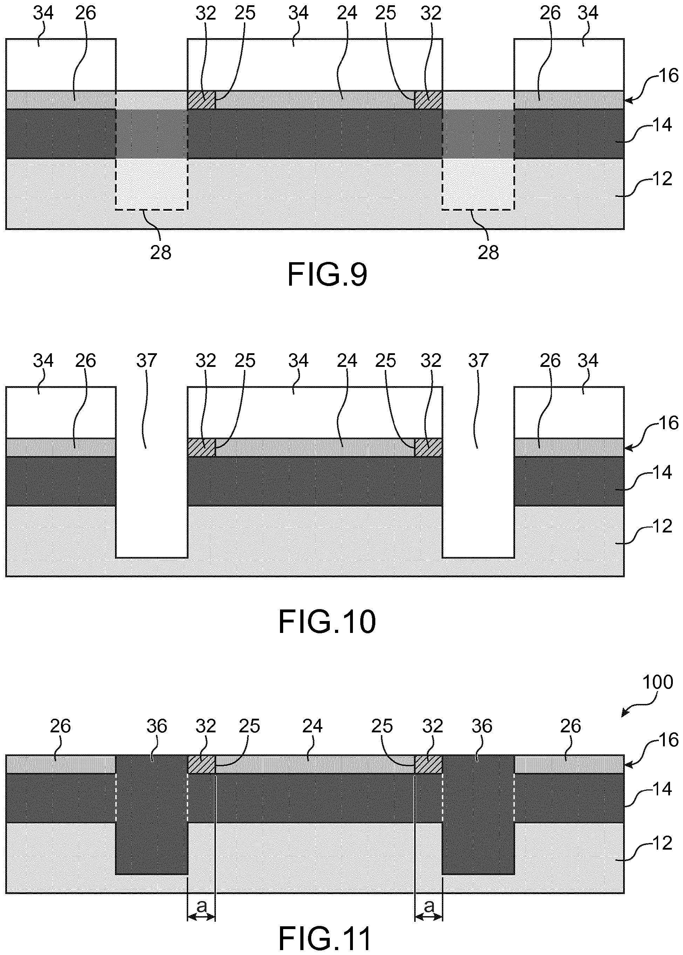

Un deuxième masque 34, correspondant à un masque de gravure, est réalisé ensuite sur la couche superficielle 16 (figure 9). La ou les ouvertures du deuxième masque 34 définissent la ou les tranchées d'isolation destinées à être réalisées au moins dans la couche superficielle 16. Dans l'exemple de réalisation décrit ici, les tranchées d'isolation sont destinées à traverser les couches 16 et 14 et une partie de l'épaisseur de la couche support 12, afin d'isoler électriquement les unes des autres les différentes zones réalisées dans la couche superficielle 16. Les couches 16, 14 et 12 sont ensuite gravées selon le motif du deuxième masque 34 (voir la figure 10). La ou les tranchées 37 formées traversent complètement les couches 16 et 14 et une partie de l'épaisseur de la couche support 12.

Grâce à la présence des portions 32 qui entourent la première partie 24 de la couche superficielle 116 qui comporte le SiGe contraint en compression, le SiGe de la première partie 24 ne se relaxe pas excessivement grâce à ces portions 32 qui maintiennent et contiennent la contrainte dans le semi-conducteur de la première partie 24 de la couche superficielle 16. En l'absence des portions 32, une relaxation excessive du SiGe se produirait suite à la gravure de la ou des tranchées 37 au moins dans la couche superficielle 16.

La ou les tranchées 37 gravées sont ensuite remplies par un ou plusieurs matériaux diélectriques, par exemple du SiO₂, afin de former des tranchées d'isolation 36. Le dépôt du ou des matériaux diélectriques peut être suivi d'un recuit de densification. Le deuxième masque 34 est ensuite retiré, achevant la réalisation du substrat 100 (voir la figure 11).

La figure 12 représente une vue de dessus de la partie de la couche superficielle 16 dans laquelle les transistors de type P sont destinés à être réalisés. Dans le plan principal de la couche superficielle 16 (plan sensiblement parallèle à l'interface entre la couche superficielle 16 et la couche diélectrique enterrée 14, ou plan parallèle aux faces de plus grandes dimensions de la couche superficielle 16), la première partie 24 de la couche superficielle 16 a par exemple une forme sensiblement rectangulaire, comme c'est le cas sur la figure 12. Cette première partie 24 de la couche superficielle 16, comprenant le SiGe contraint en compression, est entourée par les portions 32 qui comprennent du silicium et qui sont disposées contre les deux premiers bords 25 et deux deuxièmes bords 27 de cette première partie 24. Les tranchées d'isolation 36 entourent ces portions 32. La dimension nommée « L» correspond à la longueur de la première partie 24, et est parallèle à la longueur de canaux des transistors qui seront réalisés dans cette première partie 24 (la longueur des canaux correspondant à la dimension des canaux parallèles à la direction de transport des charges dans les canaux). La dimension nommée « W » correspond à la largeur de la première partie 24, et est parallèle à la largeur des canaux des transistors.

A partir du substrat 100 obtenu, des transistors sont réalisés en mettant en oeuvre les différentes étapes formant ces transistors (lithographie, gravure, réalisation des grilles, épitaxie, dopage, etc.). Des transistors FET de type P 38 sont réalisés dans la première partie 24 de SiGe contraint en compression (voir la figure 13).

Ces transistors 38 sont avantageusement réalisés avec des régions de source et de drain comprenant du SiGe avec une concentration en germanium supérieure à celle dans le SiGe contraint de la première partie 24. Ainsi, la différence de paramètre de maille entre le semi-conducteur (du SiGe dans le mode de réalisation décrit) de ces régions de source et de drain et le semi-conducteur (également du SiGe dans le mode de réalisation décrit) contraint de la première partie 24 tend à générer, ou augmenter comme c'est le cas ici, une contrainte en compression dans les canaux des transistors 38. Dans le mode de réalisation décrit ici, un transfert important de la contrainte en compression depuis les régions de source et de drain vers les canaux des transistors 38 est obtenu grâce aux portions 32 confinant le SiGe contraint de la première partie 24.

Dans une configuration usuelle, les transistors se trouvant au plus près de la tranchée d'isolation 36 sont des transistors factices ne remplissant aucune fonction électronique. Sur la première partie 24, deux transistors factices 42 sont représentés sur la figure 13. Leur grille est disposée partiellement sur les tranchées d'isolation 36. En outre, les portions 32 se trouvent également sous ces transistors factices 42.

Dans un mode préférentiel, la largeur, appelée « a » et visible sur les figures 11 et 12, des portions 32, c'est-à-dire la dimension appartenant au plan principal de la couche superficielle 16 et qui, de chaque côté de la première partie 24 de la couche superficielle 116, est sensiblement perpendiculaire aux parois latérales de la tranchée d'isolation 36, est telle que les portions 32 ne font pas partie des canaux des transistors FET de type P 38 qui ne sont pas factices. Pour cela, la largeur « a » des portions 32 est par exemple inférieure ou égale à 0,5 CPP (« Contacted Poly Pitch », qui correspond à la distance inter-grille, c'est-à-dire le pas entre les grilles de deux transistors voisins). Ainsi, dans la configuration présentée en figure 13, les portions 32 ne sont pas disposées sous la grille d'un transistor électriquement actif, c'est-à-dire dans la région de canal d'un tel transistor (la portion 32 peut par contre être disposée dans une région de source ou de drain d'un tel transistor).

Avec les portions 32 présentes contre tous les bords de la première partie 24 de la couche superficielle 16, la contrainte en compression est conservée dans le semi-conducteur de la première partie 24 de la couche superficielle 16 et une relaxation excessive de la contrainte est évitée notamment selon deux directions sensiblement perpendiculaires l'une de l'autre, l'une de ces deux directions correspondant à la direction de circulation du courant dans les canaux des transistors de type P 38 (ces deux directions correspondent à celles parallèles aux axes X et Y visibles sur la figure 12).

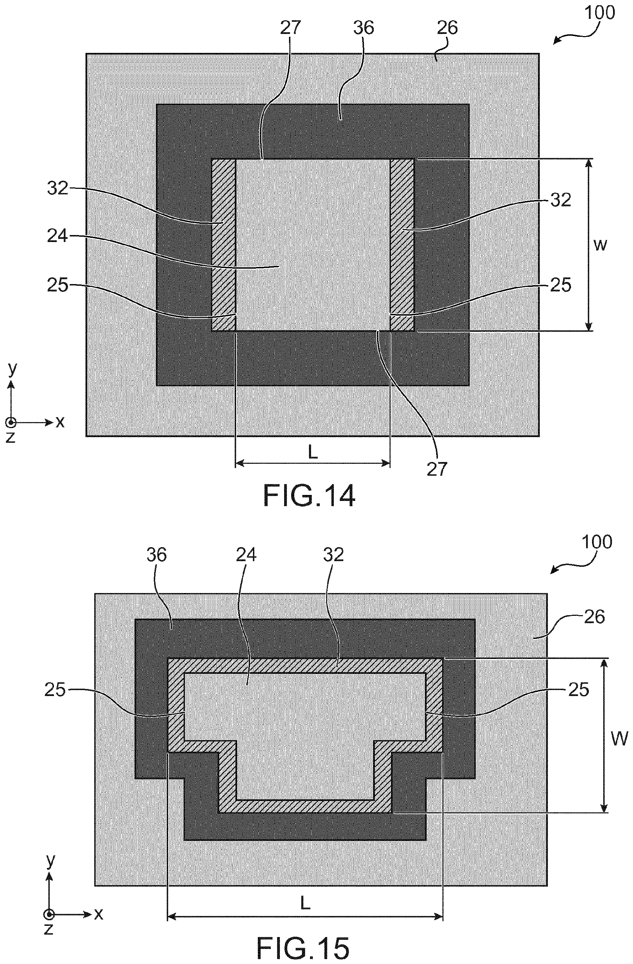

Selon une variante, il est possible que les portions 32 ne soient pas présentes contre tous les bords de la première partie 24 de la couche superficielle 16. La figure 14 représente une telle variante de réalisation. Sur cette figure, les portions 32 sont localisées contre les deux premiers bords 25 opposés de la première partie 24 de la couche superficielle 16. Les deux portions 32 sont chacune orientées, c'est-à-dire comprennent leur plus grande dimension, sensiblement perpendiculairement à la longueur des canaux des transistors destinés à être réalisés dans la première partie 24 de la couche superficielle 16. Aucune portion 32 n'est présente contre les deuxièmes bords 27 de la première partie 24 de la couche superficielle 16 qui sont sensiblement parallèles à la longueur L. Selon cette variante, une relaxation excessive de la contrainte compressive est empêchée selon l'axe parallèle à la longueur L grâce à la présence des portions 32 contre les premiers bords 25 de la première partie 24 de la couche superficielle 16. Une relaxation de la contrainte peut par contre se produire selon l'axe parallèle à la largeur W de la première partie 24 de la couche superficielle 16 en raison de l'absence de portions 32 contre les deuxièmes bords 27 de la première partie 24 de la couche superficielle 16. Ainsi, des conditions favorables au maintien de la contrainte compressive selon la longueur L et des conditions favorables à la relaxation de la contrainte compression selon la largeur W sont obtenues. Cette configuration favorise l'obtention d'une contrainte compressive plus importante selon l'axe parallèle à la longueur L.

Dans le mode de réalisation et les variantes précédemment décrits, la première partie 24 de la couche superficielle 16 dont le semi-conducteur est contraint en compression a une forme sensiblement rectangulaire. En variante, il est possible que la section de cette première partie 24, dans le plan principal de la couche superficielle 16, soit d'une forme différente d'une forme rectangulaire. La figure 15 représente un exemple de configuration dans laquelle la première partie 24 de la couche superficielle 16 a, dans le plan principal de la couche superficielle 16, une section dont la forme correspond à une combinaison de plusieurs rectangles. Sur cette figure, tous les bords de la première partie 24 de la couche superficielle 16 sont en contact avec des portions 32 assurant la non relaxation excessive de la contrainte en compression dans le semi-conducteur de la première partie 24. Dans une configuration où la section de la première partie 24 a, dans le plan principal de la couche superficielle 16, une forme autre que rectangulaire, il est également possible que certains bords orientés selon une première direction (par exemple parallèle à la largeur W) ne soient pas en contact avec des portions 32 afin de favoriser une relaxation de la contrainte selon une seconde direction perpendiculaire à la première direction.

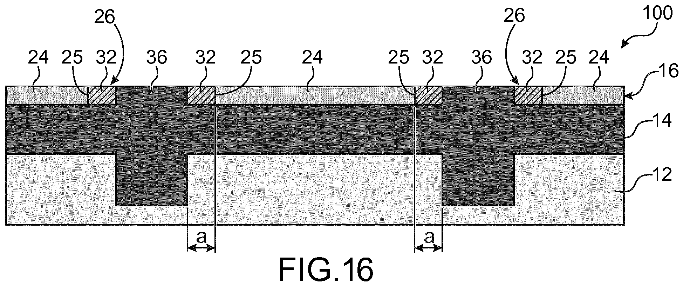

Dans le mode de réalisation et les variantes précédemment décrits, la couche semi-conductrice 16 comporte une seule première partie 24 entourée par la deuxième partie 26. Selon une variante représentée sur la figure 16, la couche semi-conductrice 16 peut comporter plusieurs premières parties 24 séparées les unes des autres par des tranchées d'isolation 36 et dont au moins deux premiers bords 25 sont en contact avec des portions 32 de la ou de plusieurs deuxièmes parties 26 de la couche semi-conductrice 16. Sur l'exemple représenté sur la figure 16, la deuxième partie 26 forme les portions 32 disposées contre des premiers bords 25 de deux premières parties 24 de semi-conducteur contraint en compression. La deuxième partie 26 peut ou non former des portions 32 disposées contre des deuxièmes bords 27 d'une ou plusieurs des premières parties 24 de la couche semi-conductrice 16. Les différentes variantes précédemment décrites peuvent se combiner avec la présente variante de réalisation.

Dans le mode de réalisation précédemment décrit, le semi-conducteur contraint en compression correspond à du SiGe, et les portions de matériau servant à éviter une relaxation excessive d'une contrainte en compression du SiGe comportent du silicium. En variante, l'utilisation de semi-conducteurs autres que le silicium et le SiGe sont possibles, autant pour le semi-conducteur contraint en compression que pour le matériau différent du semi-conducteur contraint en compression servant à former les portions de matériau évitant la relaxation excessive de la contrainte du semi-conducteur de la première portion.

## Revendications

1. Procédé de réalisation d'un substrat semi-conducteur (100), comprenant au moins la mise en oeuvre des étapes suivantes :
- réalisation d'une couche semi-conductrice (16) telle qu'au moins une première partie (24) de la couche semi-conductrice (16) comporte un semi-conducteur contraint en compression et qu'au moins une deuxième partie (26) de la couche semi-conductrice (16) comporte au moins un matériau différent du semi-conducteur contraint en compression, la deuxième partie (26) de la couche semi-conductrice (16) étant disposée, dans un plan principal de la couche semi-conductrice (16), contre au moins deux premiers bords (25) opposés de la première partie (24) de la couche semi-conductrice (16) ;
- gravure, au moins à travers la couche semi-conductrice (16), d'au moins une tranchée (37) délimitant, vis-à-vis du reste de la couche semi-conductrice (16), la première partie (24) de la couche semi-conductrice (16) et des portions (32) de la deuxième partie (26) de la couche semi-conductrice (16) disposées contre lesdits au moins deux premiers bords (25) opposés de la première partie (24) de la couche semi-conductrice (16).

2. Procédé selon la revendication 1, dans lequel le matériau différent du semi-conducteur contraint en compression ne comporte pas une contrainte en compression ou comporte une contrainte en compression de niveau inférieur à celui de la contrainte en compression dans le semi-conducteur de la première partie (24) de la couche semi-conductrice (16).

3. Procédé selon l'une des revendications précédentes, dans lequel la première partie (24) de la couche semi-conductrice (16) a, dans le plan principal de la couche semi-conductrice (16), une section de forme sensiblement rectangulaire ou combinant plusieurs rectangles.

4. Procédé selon l'une des revendications précédentes, dans lequel les portions (32) de la deuxième partie (26) de la couche semi-conductrice (16) entourent entièrement la première partie (24) de la couche semi-conductrice (16) dans le plan principal de la couche semi-conductrice (16).

5. Procédé selon l'une des revendications 1 à 3, dans lequel au moins deux deuxièmes bords opposés de la première partie (24) de la couche semi-conductrice (16), sensiblement perpendiculaires aux deux premiers bords (25), sont en contact avec la tranchée (37).

6. Procédé selon l'une des revendications précédentes, dans lequel le semi-conducteur contraint en compression comporte du SiGe et/ou le matériau différent du semi-conducteur contraint en compression comporte du silicium.

7. Procédé selon la revendication 6, dans lequel, lorsque le semi-conducteur contraint en compression comporte du SiGe et que le matériau différent du semi-conducteur contraint en compression comporte du silicium, la couche semi-conductrice (16) est réalisée par enrichissement en germanium dans une couche de silicium (16).

8. Procédé selon la revendication 7, dans lequel, avant la mise en oeuvre de l'enrichissement en germanium, la couche de silicium (16) comporte du silicium contraint en tension.

9. Procédé selon l'une des revendications 6 à 8, dans lequel le semi-conducteur contraint en compression comporte une concentration en germanium comprise entre environ 20 % et 50 %.

10. Procédé selon l'une des revendications précédentes, comportant en outre, après la gravure de la tranchée (37), la mise en oeuvre d'une étape de formation d'au moins un matériau diélectrique dans la tranchée (37), formant une tranchée d'isolation (36) électrique de la première partie (24) de la couche semi-conductrice (16) et des portions (32) de la deuxième partie (26) de la couche semi-conductrice (16).

11. Procédé selon l'une des revendications précédentes, dans lequel, lors de la réalisation de la couche semi-conductrice (16), une couche diélectrique enterrée (14) est disposée entre la couche semi-conductrice (16) et une couche support (12).

12. Procédé selon l'une des revendications précédentes, dans lequel :
- la couche semi-conductrice (16) est réalisée telle qu'elle comporte plusieurs premières parties (24) comprenant le semi-conducteur contraint en compression, la deuxième partie (26) de la couche semi-conductrice (16) étant disposée, dans le plan principal de la couche semi-conductrice (16), contre au moins les deux premiers bords (25) opposés de chacune des premières parties (24) de la couche semi-conductrice (16), et
- la tranchée (37) est gravée en délimitant les premières parties (24) de la couche semi-conductrice (16) et des portions (32) de la deuxième partie (26) de la couche semi-conductrice (16) disposées contre lesdits au moins deux premiers bords (25) opposés de chacune des premières parties (24) de la couche semi-conductrice (16).

13. Procédé de réalisation d'au moins un transistor FET (38), dans lequel ledit au moins un transistor FET (38) est de type P et est réalisé dans la première partie (24) de la couche semi-conductrice (16) d'un substrat semi-conducteur (100) obtenu par la mise en oeuvre du procédé selon l'une des revendications 1 à 12.

14. Procédé selon la revendication 13, dans lequel ledit au moins un transistor FET (38) est réalisé dans la première partie (24) de la couche semi-conductrice (16) tel que les portions (32) de la deuxième partie (26) de la couche semi-conductrice (16) ne soient pas disposées dans le canal dudit au moins un transistor FET (38).

15. Procédé selon l'une des revendications 13 et 14, dans lequel ledit au moins un transistor FET (38) a son canal orienté sensiblement perpendiculairement aux deux premiers bords (25) opposés de la première partie (24) de la couche semi-conductrice (16).
